# EUROPEAN PATENT APPLICATION

(11) **EP 2 960 929 A1**
(43) Date of publication of application: **30.12.2015**
(21) Application number: 15172869.8
(22) Date of filing: 19.06.2015
(51) Int. Cl.: H01L 21/56

(54) **PRE-APPLIED UNDERFILL**

(30) Priority: 23.06.2014 US 201414312682
(71) Applicant: Rohm and Haas Electronic Materials LLC, Marlborough, MA 01752 (US)
(72) Inventor: BARR, Robert K, Shrewsbury, MA 01545 (US); ANZURES, Edgardo, Westborough, MA 01581 (US); CALVERT, Jeffrey M., Acton, MA 01720 (US); LEI, Herong, Acton, MA 01720 (US); FLEMING, David, Northborough, MA 01532 (US); DHOBLE, Avin V., Waltham, MA 02453 (US); CHOUBEY, Anupam, Watertown, MA 02472 (US)
(74) Representative: Houghton, Mark Phillip

(57) **Abstract**

Underfill structures useful as pre-applied underfill materials comprise a polymer layer having a first filled polymer region having a first viscosity and a second filled polymer region having a second viscosity, wherein the first viscosity is less than the second viscosity. Electronic assemblies comprising a chip or die and a substrate are formed using such multi-layer structured pre-applied underfill.

## Description

This invention relates generally to the field of electronics packaging, and more particularly to the field of pre-applied underfill.

Flip chip technology, wherein the integrated circuit (IC) chips are essentially flipped over and bonded to substrates using solderable interconnects, has seen rapid growth in semiconductor packaging in recent years. The key drivers for the demand for this technology are increased I/O connections enabling greater speed and shorter connections resulting in improved signal integrity. Underfill material, which occupies the space between the flipped IC chip and the substrate, is key for reliability of the flip chip packages. Underfill material supports the electrical connections, protects them from the environment, and reduces the thermomechanical stress on the flip chip connection. Generally, underfill materials, which are polymer-based, have different coefficients of thermal expansion (CTE) from the chip and substrate components, such as the solder connections. This CTE mismatch can lead to thermomechanical stresses that can cause device failure, such as when the device is subjected to temperature cycles. In order to reduce this CTE mismatch, underfill materials typically contain an inorganic filler, such as silica.

Dispensing the underfill at the edge of the chip on the substrate and allowing it to flow in the gap between the chip and substrate under capillary action has been the most common method of incorporating underfills in the packages. In certain scenarios, the capillary flow can be slow, such as when high levels of filler are added to the underfill material, and/or incomplete resulting in voids in the package and also possible non-homogeneity in the underfill between polymer and filler, due to settling of the filler during the capillary flow. This problem can be even more serious with increasing chip size and/or decrease in pitch size of the interconnect structures on a flip chip die.

Pre-applied underfills have been developed as an alternative to capillary underfills. The underfill material can be applied to the wafer or mounting substrate by a variety of techniques, such as film lamination, spin coating or screen printing process. U.S. Pat. No. 6,861,285 describes a process where a plurality of underfill layers is applied to a bumped wafer, with at least 1 underfill layer containing a filler material and at least 1 underfill layer that is free or substantially free of filler material, where each layer of underfill material is individually applied. The underfill layers containing filler are first applied on the wafer. After the desired number of such filled underfill layers are applied, then chemical and/or mechanical methods are used to remove the underfill material from the tops of the bumps and expose the top surface of the bumps. Such methods include polishing or grinding, dry or wet etching, chemical mechanical polishing, reactive ion etching, laser milling, and laser ablation. Next, the layer of underfill material that is free or substantially free of filler material is applied to the surface of the filled underfill layers and over the exposed top surface of the solder bumps. Finally, the wafer is joined to a substrate, where the solder bumps are brought into contact with corresponding bonding pads on the substrate. The process described in this patent requires a chemical and/or mechanical removal step during which the solder bumps can be easily damaged leading to a potentially high rate of device failures. There remains a need for an improved process for applying underfill material in making IC assemblies.

U.S. Pat. App. Pub. No. 2008/0314618 discloses an insulating laminate material for printed circuit boards, where such laminate material has a top layer having an average surface roughness of ≤ 0.5 µm that is suitable for electroless plating, and an optional second layer. The top layer comprises a certain polyimide resin having a siloxane structure, and the second layer is a thermosetting resin having better bonding ability to an inner circuit board than the top layer. Accordingly, the top layer and optional second layer are composed of different types of polymeric materials. The top layer may contain from 0 to 30 wt% of filler, and the optional second layer has a higher filler content than the top layer. The optional second layer has a melt viscosity of ≤ 20000 Pa-S, and is designed to fill gaps between circuit lines in order to provide sufficient adhesion to an inner circuit board layer. The linear expansivity (that is, the CTE) of the top layer and the second layer are different, as each layer is designed to address different properties. Such a laminate structure is not suitable for attaching an IC to a substrate.

The present invention provides an underfill structure comprising in order: a top film layer, a polymer layer, and a bottom film layer, wherein the polymer layer comprises in any order a first filled polymer region having a first viscosity and a second filled polymer region having a second viscosity, wherein the second viscosity is ≥ 1.5 times the first viscosity. Preferably, the total amount of inorganic filler present in the first filled polymer region, on weight percentage basis, is substantially the same as the total amount, on a weight percentage basis, of inorganic filler present in the second filled polymer region.

The present invention also provides a method of forming an electronic package comprising: providing a component having interconnect structures on a surface thereof; providing a substrate having conductive bond pads on a surface thereof; providing the underfill structure described above; removing the bottom film from the underfill structure; laminating the underfill structure to the component surface having interconnect structures thereon or the substrate surface having conductive bond pads thereon; removing the top film layer; registering a top portion of the interconnect structures with the conductive bond pads to form a unit; and causing the interconnect structures to electrically connect to the conductive bond pads. Preferably, the underfill structure is arranged such that the first filled polymer region is directly adjacent to the substrate surface.
Figs. 1A and 1B are schematic drawings, in cross-section, of alternate embodiments of an underfill structure of the invention.
Fig. 2 is a schematic drawing showing a lamination process of disposing an underfill structure of the invention onto a component having metal pillar interconnect structures.
Figs. 3A and 3B are cross-sectional schematic drawings showing an alternate embodiments of the underfill structure of the invention laminated onto a component having metal pillar interconnect structures.
Figs. 4A and 4B are cross-sectional schematic drawings illustrating an underfill structure of the invention laminated onto a substrate having conductive bond pads.
Fig. 5 is a cross-sectional schematic drawing showing an electronic package prepared from the laminate structure of the invention.
Fig. 6 is an optical image showing an electronic package formed from the present laminate structure.
Fig. 7 is an optical image showing an electronic package formed from a comparative laminate structure.

As used throughout this specification, the following abbreviations shall have the following meanings, unless the context clearly indicates otherwise: °C = degrees Celsius; g = gram; kg = kilogram; µm = micron = micrometer; mm = millimeter; min. = minute; DI = deionized; mol = mole; and rpm = revolutions per minute. All amounts are percent by weight ("wt%") and all ratios are weight ratios, unless otherwise noted. All percentages by weight are based on the total weight of the composition, unless otherwise noted. All numerical ranges are inclusive and combinable in any order, except where it is clear that such numerical ranges are constrained to add up to 100%. In the figures, like reference numerals refer to like elements. The articles "a," "an" and "the" refer to the singular and the plural, unless the context indicates otherwise. "Alkyl" refers to linear, branched and cyclic alkyl. "Aryl" refers to aromatic carbocycles and aromatic heterocycles. The term "(meth)acrylate" includes both acrylates and methacrylates. Likewise, the term "(meth)acrylic" includes both acrylic and methacrylic.

It will be understood that when an element is referred to as being "on" or "adjacent to" another element, it can be directly on or directly adjacent to the other element or intervening elements may be present therebetween. When an element is referred to as being "directly on" or "directly adjacent to" another element, there are no intervening elements present.

It will also be understood that, although the terms first, second, third, etc. may be used herein to describe various elements, components, regions, layers, portions or sections, these elements, components, regions, layers, portions or sections should not be limited by these terms. These terms are only used to distinguish one element, component, region, layer or section from another element, component, region, layer, portion or section. Thus, a first element, component, region, layer, portion or section could be termed a second element, component, region, layer or section without departing from the teachings of the present invention.

Furthermore, relative terms, such as "lower" or "bottom" and "upper" or "top," may be used herein to describe one element's relationship to another element as may be illustrated in the Figures. It will be understood that relative terms are intended to encompass different orientations of the device in addition to the orientation depicted in the Figures. For example, if the device in one of the Figures is turned over, elements described as being on the "lower" side of other elements would then be oriented on "upper" sides of the other elements. The exemplary term "lower" can, therefore, encompass both an orientation of "lower" and "upper," depending on the particular orientation of the Figure. Similarly, if the device in one of the Figures is turned over, elements described as "below" or "beneath" other elements would then be oriented "above" the other elements. The exemplary terms "below" or "beneath" can, therefore, encompass both an orientation of above and below.

The present invention provides a dry film structure useful to form a pre-applied underfill in electrical assemblies. The present structure comprises, in order: a top film layer, a polymer layer, and a bottom film layer, wherein the polymer layer comprises in any order a first filled polymer region having a first viscosity and a second filled polymer region having a second viscosity, wherein the second viscosity is ≥ 1.5 times the first viscosity. As used herein, the term "filled" in reference to polymer regions means that the particular polymer region comprises an amount of an inorganic filler. The structure may optionally comprise one or more layers of additional materials, such as buffer layers, release layers, and the like. Preferably, the structure comprises a buffer layer, and more preferably the buffer layer is disposed between the top film layer and the polymer layer. Optionally, the structure may include a release layer disposed between the bottom film layer and the polymer layer.

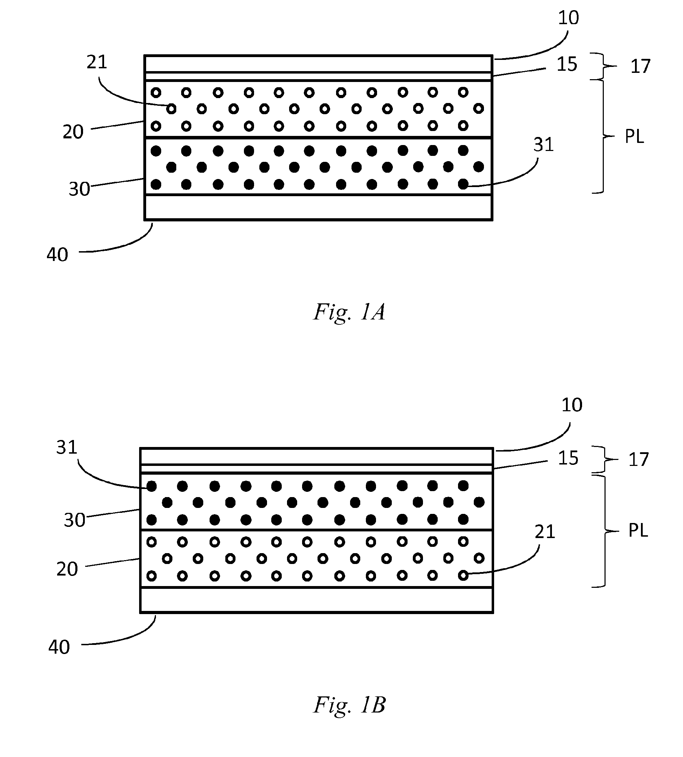

In one embodiment of the present structure, the top film layer is disposed on the first filled polymer region of the polymer layer, and preferably a buffer layer is disposed between the top film layer and the first filled polymer region. Fig. 1A illustrates a cross-sectional schematic diagram of one embodiment of the invention having, in order, top film portion 17 composed of top film layer 10 and optional buffer layer 15, polymer layer PL and bottom film 40, where polymer layer PL is composed of first filled polymer region 20 comprising inorganic filler 21 disposed on second filled polymer region 30, the second polymer region 30 comprising inorganic filler 31. In Fig. 1A, optional buffer layer 15 is disposed between the top film layer 10 and first filled polymer region 20 of the polymer layer, and the second filled polymer region 30 of the polymer layer is disposed directly on bottom film 40. In an alternate embodiment, the top film layer is disposed on the second polymer region, and preferably a buffer layer, is disposed between the top film layer and the second filled polymer region. Fig. 1B illustrates a cross-sectional schematic diagram of this alternate embodiment of the invention having, in order, top film portion 17 composed of top film layer 10 and optional buffer layer 15, polymer layer PL composed of second filled polymer region 30 comprising inorganic filler 31 disposed on first filled polymer region 20 comprising inorganic filler 21, where the first filled polymer region 20 is disposed on bottom film layer 40. Either structure of Figs. 1A and 1B may optionally contain a release layer (not shown) disposed between the polymer layer PL and bottom film layer 40. In use, the bottom film is removed from the underfill structure before the structure is laminated to a surface, and, after lamination to a surface, the top film layer is then removed to provide the polymer layer on the surface as a pre-applied underfill.

The top film layer functions to protect the polymer layer during storage and handling, and to help position the polymer layer between interconnect structures during lamination. The top film layer has sufficient film integrity such that the top film layer is able to be removed from the polymer layer by peeling. Since the top film layer is removed from the underfill structure, such as by peeling, the adhesion between the top film layer and the polymer layer is typically low to moderate. A wide variety of polymers may be used as the top film layer, provided they meet the above criteria, including free-radical polymerization polymers, graft copolymers, step-growth polymerization polymers, and the like. Polymers useful as the top film layer include copolymers of: polyolefins; polyolefin copolymers; polyvinylchloride; polyvinylchloride copolymers; polydinylidenechloride; polyurethanes; polyurethane copolymers; poly(meth)acrylates; and poly(meth)acrylate copolymers. Preferred polyolefins include polyethylene, polypropylene, polybutylene, polyisobutylene, polybutadiene, and polyisoprene. Elastomers are another preferred class of polymeric materials useful as the top film layer. Such elastomers include, but are not limited to: polyolefin elastomers; ethylene vinyl acetate; polyether block amides; polyacrylic rubber, ethylene propylene rubber; ethylene propylene diene rubber; polyisobutylene polybutadiene; silicone-urethane copolymers; polybutadiene-polyurethane copolymers; styrene-block copolymers; styrene-butadiene copolymers; and polyvinylchloride elastomers. Polyolefin elastomers are well known in the art and are typically copolymers of ethylene and another alpha-olefin. In addition, it is preferred that the top film layer is sufficiently pliable to deform without deforming interconnect structures during lamination. The top film layer may have any suitable thickness, such as from 5 to 250 µm, and preferably from 10 to 150 µm.

Optionally, a buffer layer is disposed between the top film layer and the polymer layer. While not wishing to be bound by theory, it is believed that the buffer layer acts as a buffer or cushion between the top film layer and interconnect structures during lamination, allowing for movement of the top film layer during lamination without deforming the interconnect structures. Any polymeric material that is sufficiently pliable to allow for movement of the top film layer during lamination or to deform during lamination without deforming interconnect structures may be used as the buffer layer. The buffer layer may also function to improve the adhesion between the top film layer and the polymer layer. It is preferred that the buffer layer is an adhesive material. A wide variety of adhesive materials known in the art may be used as the buffer layer, provided the adhesive material is peelable and not permanent. Preferably, the adhesive material is a pressure sensitive adhesive (PSA). Pressure sensitive adhesives are well-known in the art and typically comprise an elastomer, such as rubber, (meth)acrylates or silicones. When a buffer layer is used, it is preferred that the buffer layer substantially remains with the top film layer when the top film layer is removed from the structure and further preferred that no buffer layer residue is left on the polymer layer. Any buffer layer residue remaining on the polymer layer after removal of the top film layer may be removed by contact with an appropriate remover, such as a suitable organic solvent. It is preferred that a buffer layer is disposed between the top film layer and the polymer layer, and more preferably that a PSA layer is disposed between the top film layer and the polymer layer. When used in the present invention, the thickness of the buffer layer is not critical, but is typically in the range of 5 to 100 µm, and preferably 10 to 50 µm. An advantage of the buffer layer is that it can also modify the adhesion energy between the top layer and the polymer layer.

In a preferred embodiment, a PSA tape is used in the present structure to form the top film layer and the buffer layer. A PSA tape is composed of a PSA layer disposed directly on a polymer film. The polymer film of the PSA tape functions as the top film layer in the present structure while the PSA layer functions as a buffer layer. A wide variety of PSA tapes are commercially available and may be used in the present invention. Particularly useful PSA tapes are backgrinding tapes. Exemplary PSA tapes are those sold under the trade names BG Tape (available from Lintec Corp.), BG-HTCR100-PET (available from AI Technology, Inc.), ICROS™ Tape (available from Mitsui Chemicals), ELEGRIP™ Tape (available from Denka), as well as other backgrinding tape available from Toyo Adtec, Furukawa Electric, and other commercial suppliers. Preferably, the tape has a UV light sensitive adhesive layer which possess relatively strong adhesion to a surface prior to exposure to appropriate UV radiation, and relatively weak adhesion after exposure to appropriate UV radiation. That is, upon exposure to UV radiation, the tape becomes more readily releasable. Accordingly, a step of UV radiation exposure may be employed in the top film removal step when a film having a UV sensitive adhesive is employed.

The polymer layer of the present underfill structures is composed of a plurality of polymer regions. The polymer layer comprises at least 2 filled polymer regions, a first filled polymer region having a first viscosity and a second filled polymer region having a second viscosity, where the second viscosity is ≥ 1.5 times the first viscosity. Preferably, the polymer layer is composed of 2 filled polymer regions. It will be appreciated that more than 2 filled polymer regions may be used, although such additional polymer regions may add to the cost of the process. The polymer layer may be composed of a single polymer layer having at least 2 distinct filled regions, or alternatively, the polymer layer may be composed of a plurality of individual polymer layers, where such plurality of individual polymer layers forms at least 2 distinct filled regions. Each polymer region may be composed of a single polymer layer or may be composed of a plurality of individual polymer layers. It is preferred that the polymer layer is composed of 2 individual polymer layers, each individual polymer layer forming a distinct filled polymer region.

The polymer layer may be comprised of any suitable polymer useful as an underfill. Each polymer region comprises one or more curable polymers, one or more crosslinkers, one or more thermal curing agents (catalysts), one or more inorganic fillers, and optionally one or more additives chosen from the group of fluxing agents, flow additives, flexibilizers, solvents, antifoam agents, impact modifiers, surfactants, adhesion promoters, and mixtures thereof. Any suitable curable polymers, crosslinkers, thermal curing agents and optionally additives may be used in any polymer region. Suitable curable polymers are those useful as an underfill. Preferably, the curable polymer is an epoxy, and more preferably a polymer of an epoxy and a di-functional amine monomer. It is further preferred that a di-functional epoxy monomer is used. A polymer formed from a tri-functional epoxy monomer may be used, provided the amount of the tri-functional epoxy is ≤ 5 wt% of the total weight of the monomers used to form the polymer, and preferably ≤ 3 wt%. Exemplary epoxies useful in forming the curable polymer include, but are not limited to: diglycidyl ether of bisphenol A; diglycidyl ether of bisphenol F; diglycidyl ether of bisphenol S; diglycidyl ether of anthracene; diglycidyl ether of dicyclopentadiene; diglycidyl ether of naphthalene; diglycidyl ether of biphenyl; diglycidyl ether of propyleneglycol; and diglycidyl ether of dipropyleneglycol. Useful amines in forming the epoxy/amine polymers include, but are not limited to: 1,8-diaminomenthane; 2,6-diamino-2,6-dimethyl-5-phenylheptan-3-ol; 2,6-diamino-2,5,6-trimethylheptan-3-ol; trimethyleneglycol di-p-aminobenzoate; and oligomeric diamine polytetramethyleneoxide-di-p-aminobenzoate. Suitable crosslinkers are any aliphatic or aromatic material having two or more functional groups chosen from carboxylic acids, hydroxyls, and amines. Preferred crosslinkers include phenolic hardeners, such as novolac resins and diphenol biphenyls, and dihydrazide hardeners. Suitable novolac resins include, without limitation, phenol novolac, cresol novolac and resol novolac. Exemplary phenolic hardeners are those available under the trade names DL-92, MEH 7800-4S, MEH 7851SS and MEH 7500 from Meiwa Plastic Industries. Exemplary dihydrazide hardeners include adipic dihydrazide, isophthalic dihydrazide, sebasic acid dihydrazide, and those available under the trade names Ajicure LDH and Ajicure VDH, available from Ajinomoto Fine-Techno Co., Inc. Crosslinkers may be present in an amount of from 0 to 70 wt%, preferably from 2.5 to 50 wt%, and more preferably from 2.5 to 25 wt%. Suitable thermal curing agents include, without limitation, nitrogen or phosphorus compounds. Preferred curing agents are: tetrabutylphosphonium hexafluorophosphate, tetraphenylphosphonium tetraphenylborate, tetrabutylphosphonium tetraphenylborate, tetraethylphosphonium hexafluorophosphate, tetrabutylphosphonium tetrafluoroborate; imidazole salts such as those available from Air Products under the Curezol™ brand; triaryl phosphines such as triphenyl phosphines; tertiary amines such as benzyldimethyl amine; urea compounds such as N-(4-chlorophenyl)-N,N-dimethyl urea, 2,4-toluene-bis-dimethyl urea, phenyl dimethyl urea, toluene-bis-dimethyl urea, 4,4'-methylene-bis (phenyl dimethyl urea), and cycloaliphatic bisureas; and dicyandiamide. Thermal curing agents may be present in an amount of from 0 to 10 wt%, preferably from 0 to 5 wt% and more preferably from 0.01 to 3 wt%. Preferably, each of the first and second polymer regions comprise a fluxing agent. Suitable fluxing agents are materials containing carboxylic acid, phenol or amine functional groups. A fluxing agent may be present in each polymer region in an amount of from 0 to 50 wt%, preferably 0.01 to 20 wt%, and more preferably from 0.01 to 10 wt%. It is further preferred that the curable polymer forming a particular polymer region also function as a fluxing agent. Preferred polymers functioning as fluxing agents typically comprise a secondary amine moiety, where such polymer is present in the first polymer region in an amount of 0.1 to 70 wt%, more preferably from 20 to 70 wt%, and even more preferably 30 to 70 wt%. Preferred optional additives are di-, tri-, and tetra-functional epoxy monomers, which may function as flexibilizers or hardeners, among other functions, depending, in part, on the number of epoxy groups in the monomer.

A wide variety of curable polymers, crosslinkers, and thermal curing agents may be used to form each of the polymer regions of the invention. It is preferred that the polymer chosen for the first polymer region and the polymer chosen for the second polymer region are compatible, that is, that upon heating such as when the interconnect structures are electrically connected to bond pads, optionally in the presence of pressure, the two distinct polymer regions will form a unitary polymer region. It is further preferred that the curable polymer used in the first polymer region be of the same class of curable polymers used in the second polymer region. Even more preferably, the curable polymer used to form the first polymer region is the same as that used to form the second polymer region. The crosslinker used in the first polymer region may be the same as, or different from, the crosslinker used in the second polymer region. The curing agent used in the second polymer region may be the same as or different from the curing agent used in the first polymer region. The amount of a component, such as the curable polymer, crosslinker or thermal curing agent, used in the first polymer region may be the same as, or different from, the amount of that component used in the second polymer region. Any suitable solvent may be used in the second polymer region.

Inorganic filler is used to lower the overall coefficient of thermal expansion (CTE) of the polymer layer, and accordingly, of the underfill. The inorganic filler used in the present invention is non-electrically conductive and inert, that is, it will not react with or destabilize the polymer layer. An amount of inorganic filler is used in the polymer layer in order to get the CTE of the underfill close to the relatively lower CTE of the component (e.g., silicon in the case of a silicon wafer) for silicon to silicon bonding, or between the relatively lower CTE of the component (e.g., silicon) and the relatively higher CTE of an organic substrate (such as a circuit board, e.g., FR4). The proper choice of CTE is necessary for stress mitigation during manufacturing and subsequent use of the electronic assembly.

Preferably, the inorganic filler used in both the first and second filled polymer regions is chosen from silica, a metal oxide or a ceramic. Suitable ceramic inorganic fillers are crystalline oxides, nitrides or carbides. It is preferred that the inorganic filler is chosen from silica, alumina, zirconia, berylia, ceria, zinc oxide, silicon nitride, aluminum nitride, silica coated aluminum nitride, boron nitride, and silicon carbide, and more preferably silica, alumina, zirconia, silicon nitride, aluminum nitride, boron nitride, and silicon carbide. Mixtures of inorganic filler may be used. The inorganic filler may have any suitable shape and size. Preferably, the inorganic filler has a spherical or substantially spherical shape. Such spherical shape minimizes surface area and allows for a higher loading of filler in the polymer region. It is preferred that the inorganic filler has a size, such as a mean particle size, that will not impede the penetration of either polymer region by interconnect structures. It is preferred that the inorganic filler has a mean particle size of 0.005 to 10 µm, more preferably from 0.005 to 5 µm, and yet more preferably 0.01 to 3 µm. Mixtures of inorganic filler particle sizes may be used in a polymer region. For example, a polymer region of the invention may comprise a first silica filler having a first mean particle size and a second silica filler having a second mean particle size. Inorganic filler useful in the present invention includes a ceramic having a core-shell structure, where a ceramic material core is surrounded by an inorganic material shell, such as silica coated aluminum nitride. The inorganic filler may optionally be treated with an adhesion promoter to modify the surface chemistry of the filler particle, for example, to allow the inorganic filler particle to react with the polymer or crosslinker used in the polymer region. Modifying the surface chemistry of the filler may improve fracture toughness and may improve the dispersion of the filler in the polymer region.

The inorganic filler is present in the first filled polymer region in an amount of ≥ 30 wt%, preferably > 30 wt%, more preferably ≥ 35 wt%, yet more preferably ≥ 40 wt%, even more preferably from 30 to 80 wt%, still more preferably from 35 to 80 wt%, and yet more preferably from 40 to 75 wt%. The inorganic filler is present in the second filled polymer region in an amount of ≥ 30 wt%, preferably > 30 wt%, more preferably ≥ 35 wt%, yet more preferably ≥ 40 wt%, even more preferably from 30 to 80 wt%, still more preferably from 35 to 80 wt%, and yet more preferably from 40 to 75 wt%. Preferably, the total amount of inorganic filler present in the first filled polymer region, on a weight percentage basis, is substantially the same as the total amount, on a weight percentage basis, of inorganic filler present in the second filled polymer region. As used herein, the term "substantially the same" amount of inorganic filler means that the total amount of inorganic filler in the first filled polymer region is within 10% of the total amount (on a weight percentage basis) of inorganic filler in the second filled polymer region, preferably within 5%, more preferably within 3%, and even more preferably within 2%. Yet more preferably, the total amount of inorganic filler present in the first polymer region is the same as the total amount of inorganic filler present in the second polymer region. It will be appreciated by those skilled in the art that a gradient of inorganic filler in either or both of the first and second polymer regions may be achieved by using a plurality of individual polymer layers in the respective polymer region, where the individual polymer layers have differing levels of inorganic filler. However, it is preferred that the present laminate structures do not have such a gradient of inorganic filler in either the first or second polymer regions, and preferably in both the first and second polymer regions. It will be appreciated by those skilled in the art that the amount of inorganic filler selected for a polymer region is based in part on the desired CTE of the polymer layer, the desired transparency of the polymer layer, and the desired flow characteristics of the polymer layer, among other parameters.

The first filled polymer region has a lower viscosity than the second filled polymer region. The second filled polymer region has a viscosity that is ≥ 1.5 times, preferably ≥ 2 times, more preferably ≥ 2.5 times, yet more preferably ≥ 3 times, and even more preferably ≥ 4 times, the viscosity of the first polymer region. Typically, the viscosity of the second polymer region is from 1.5 to 1000 times, and preferably from 1.5 to 500 times, the viscosity of the first polymer region. The first filled polymer region has a viscosity in the range of 0.1 to 1000 Pa-S at 125 °C as measured using a parallel plate rheometer, preferably from 1 to 1000 Pa-S, and more preferably from 1 to 500 Pa-S. The second filled polymer region has a viscosity in the range of 1000 to 100,000 Pa-S at 125 °C as measured using a parallel plate rheometer, preferably from 5000 to 100,000 Pa-S, and more preferably from 5000 to 50,00 Pa-S. Such viscosities can easily be achieved, such as by: appropriate selection of the particular inorganic filler or mixture of inorganic fillers; selection of filler particle size; surface treating the inorganic filler; filler loading in the polymer region; the size (molecular weight and/or degree of branching) of the curable polymer used in the particular polymer region; the addition of thixotropic agents; among other variables known to those skilled in the art. For example, increasing filler loading in a polymer region will increase the viscosity of that region, while decreasing the mean particle size of the inorganic filler will increase the viscosity of the particular polymer region. Increasing the molecular weight and/or degree of branching of the curable polymer used to form a polymer region will also increase the viscosity of that polymer region. Exemplary thixotropic agents are those that interact or bind with the inorganic filler, such as those sold by Altana AG under the trade names BYK 405, BYK 410, and BYK 415.

Since both the top and bottom film layers are removed from the present underfill structure before an electronic assembly is formed, the only critical dimension in the underfill structure is the thickness of the polymer layer. As the height of interconnect structures vary considerably depending upon the particular structures used, there is no specific range of thicknesses for the polymer layer in the structures of the present invention. The total thickness of the polymer layer, that is, the combined thicknesses of the first and second polymer regions, may be greater than, equal to, or less than the height of the interconnect structures used to form the electronic assembly. The height of the second polymer region is critical and is equal to or less than the height of the interconnect structures, and preferably is less than the height of the interconnect structures. The first polymer region, which may also function as a fluxing agent, may cover the top of the interconnect structures. If the height of the polymer layer is much greater than the height of the interconnect structures, there is a risk that the polymer layer will bleed out along the substrate or creep up the sidewall of the die. There is also the potential that it will prevent good contact between the interconnect structures and the conductive pads to which they are to be electrically connected. If the height of the polymer layer is too much less than the height of the interconnect structures, then following assembly of a component to a substrate, an undesirable gap may remain between the polymer layer and the substrate or the component. The difference in height between the top of the interconnect structures and the top surface of the polymer layer should be sufficient to account for spreading of the interconnect structures and of the underfill during assembly of the electronic device, as a component and substrate are brought into contact and heated to solder the component to the substrate, that is, electrically connect the interconnect structure to the conductive bond pads. After such assembly, the polymer layer should fill the space between the surface of the component and the surface of the substrate and form a fillet along the edge of the component.

In general, each of the first polymer region and second polymer region may have any suitable thickness, provided that the thickness of the second polymer region is greater than or equal to the thickness of the first polymer region. Preferably, the ratio of thickness of the first polymer region to the second polymer region is from 0.1:9.9 to 1:1, and more preferably from 1:9 to 1:1. Suitably, for a polymer layer comprising only first and second polymer regions, the first polymer region has a thickness of 0.1 to 50%, and preferably from 1 to 50%, of the thickness of the polymer layer in the underfill structure, and the second polymer region has a thickness of from 99.9 to 50%, and preferably from 99 to 50% of the thickness of the polymer layer. Preferably, the thickness of the second polymer region is much greater than the thickness of the first polymer region. As an example, the first polymer region may have a thickness in the range of 0.1 to 10 µm (or greater), and the second polymer region may have a thickness of 5 to 200 µm (or greater), although a wide variety of thicknesses may be used in the present underfill structures.

The bottom film layer in the present underfill structure typically functions as a support for the polymer layer and any other layers of the dry film underfill structure during manufacture, storage and subsequent processing. In general, the bottom film layer is removed from the dry film (polymer layer), such as by peeling, and is typically removed before the present underfill structure is laminated to a surface. Accordingly, adhesion between the bottom film layer and the polymer layer is typically low to moderate to allow for ease in separation. In general, the bottom film layer is removed before the top film layer, so the adhesion between the bottom film layer and the polymer layer is relatively lower than the adhesion between the top film layer and the polymer layer. The particular material used for the bottom film layer can vary widely and the particular material used is not critical. The material for the bottom film layer may be rigid or flexible, and is typically in roll or sheet form. Suitable bottom film layer materials include, without limitation: polyester such as polyethylene terephthalate (PET); paper; nylon; glass; cellulose acetate; polyolefin; polyimide; polyurethane; poly(meth)acrylate; metal sheet; epoxy laminate; copper coated fiberboard; and the like. Materials, such as PET, paper and the like, may be coated in various ways. For example, PET may be resin-coated, flame or electrostatic discharge treated, or slip treated. Paper used as a bottom film is typically resin-coated, such as polyethylene-coated paper or polyvinyl alcohol coated paper. Preferably, the bottom film layer is a polyolefin, and more preferably polyethylene. While the bottom film layer typically has a thickness of from 5 to 250 µm, the exact thickness of the bottom film layer is not critical as long as it can support the other layers of the underfill structure.

Optionally, a release layer may be disposed between the bottom film layer and the polymer layer. A release layer is typically used when the adhesion between the bottom film layer and the polymer layer is relatively too high, such that the bottom film layer is not easily removable from the polymer layer without damage to the polymer layer or other layers of the underfill structure. Any release layer used needs to render the bottom film layer peelable from the polymer layer. When a release layer is used, it is preferred that the release layer substantially remains with the bottom film layer when the bottom film layer is removed from the underfill structure and that no release layer residue is left on the polymer layer. Any release layer residue remaining after removal of the bottom film layer may optionally be removed, such as by contact with a suitable organic solvent. It is preferred that a release layer is not used.

Underfill structures of the present invention may be formed by depositing a polymer layer on a bottom film, such as a PET film. The polymer layer is formed by first forming a polymer region by disposing a filled polymeric material on the top surface of the film. The filled polymer material layer may be laminated to the bottom film or may be coated using a slot die, knife over roll, or by another suitable coating method known to those skilled in the art, and is then typically dried before further processing. Additional filled polymeric material layers may be deposited if needed to achieve a desired thickness of the filled polymer region (which may be the first or second polymer region). Next, one or more layers of filled polymeric material for forming a different polymer region having a different viscosity from the prior deposited polymeric material, is laminated to or coated onto the filled material layer by gravure coating or other suitable coating method known to those skilled in the art, and is then typically dried before further processing. The top film layer is then laminated onto the surface of the polymer layer using pressure, optionally with heating. When a buffer layer is used in the present underfill structures, it is preferred that the buffer layer be first coated onto the top film layer by any suitable method used in the art, and then the top film layer containing the buffer layer is laminated to the unfilled polymer layer using pressure, and optionally heat.

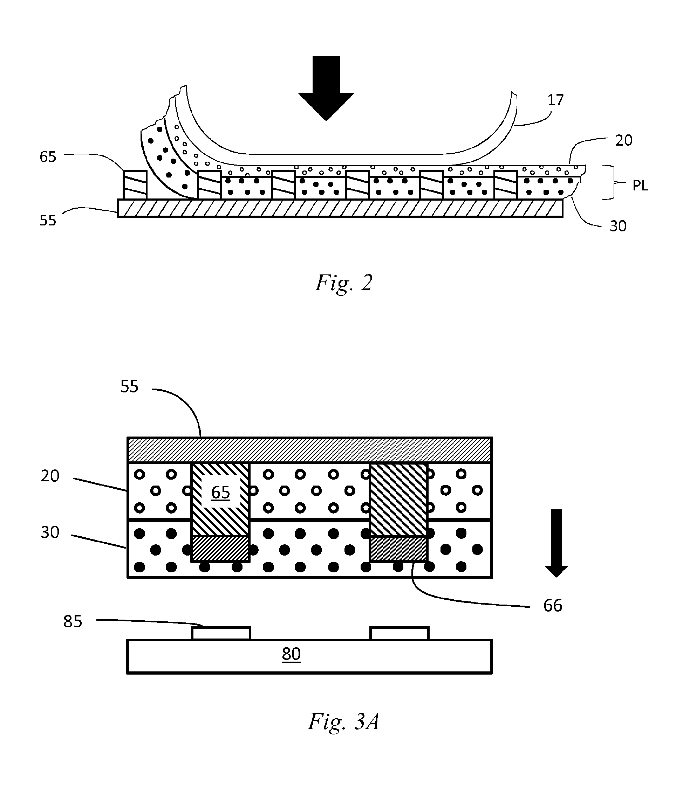

A wide variety of dry film lamination techniques are known in the art and any of these techniques are suitable for laminating the present underfill structure to a surface, such as hot roll lamination, vacuum lamination, wet lamination, and combinations of the foregoing, among others. See, for example, the lamination techniques disclosed in U.S. Pat. App. Ser. No. 14/017,264. Vacuum lamination is preferred. Fig. 2 illustrates a vacuum lamination technique using the underfill structure of Fig. 1A. First, bottom film layer 40 is removed from the underfill structure using any suitable method (step not shown), next the underfill structure is laminated to a surface of component 55 having metal pillars (interconnect structures) 65 disposed on its surface. A silicone rubber diaphragm in the vacuum lamination machine (not shown) can be used to press and adhere the underfill structure onto the surface of component 55 using heat and pressure. The vacuum inside the vacuum chamber can be used to pull down the diaphragm onto the component surface and pressure can also be applied behind the diaphragm (indicated by the arrow in Fig. 2). Any pressure applied behind the diaphragm works in conjunction with the vacuum pull-down to push polymer layer PL between metal pillars 65. Polymer layer PL is composed of first filled polymer region 20 and second filled polymer region 30, where the second polymer region has a viscosity that is ≥ 1.5 times the viscosity of the first polymer region. The overall height of polymer layer PL (first polymer region 20 + second polymer region 30) may be less than (not shown), equal to (not shown), or greater than (shown) the height of metal pillars 65, while the height of second polymer region 30 is less than the height of metal pillars 65. In Fig. 2, first polymer region 20 covers the tops of metal pillars 65. After the atmosphere is introduced into the vacuum chamber, top film portion 17 (comprising top film layer 10 and optional adhesive layer 15) is removed from the structure using any suitable method resulting in a pre-applied underfill (polymer layer PL) disposed between metal pillars 65 on the surface of component 55.

As discussed above in reference to Fig. 2, the total height (h) of the polymer layer is less than, equal to, or greater than the height of the interconnect structures on the surface to which the underfill structure is laminated, while the height of the second polymer region is less than or equal to the height of the interconnect structures, and preferably is less than the height of the interconnect structures. In Fig. 2, top film portion **17** is composed of an elastomeric top film layer and a buffer layer (PSA). Metal pillars **65** are not deformed by the lamination method or by top film portion **17.** While not wishing to be bound by theory, it is believed that the pliability of top film portion **17,** and in particular the pliability of the buffer layer of top film portion **17,** allows for such lamination without substantially deforming the interconnect structures. When the total height h of the polymer layer is sufficiently close to the height of metal pillars **65,** the top film portion **17** is deformed by the metal pillars during lamination without being pierced by them. It will be appreciated by those skilled in the art that when the height of the first polymer region is such that it covers the tops of interconnect structures, the height of deformations may be reduced or their presence even eliminated.

Underfill structures of the present invention may be laminated to a variety of substrates, such as components having active devices and substrates having conductive bond pads. Suitable components include, without limitation, integrated circuits, among others. Suitable substrates include printed circuit boards (PCBs), package substrates, and the like. For example, a flip chip may be mounted on a package substrate and the resulting package mounted on a PCB, or alternatively, a flip chip may be directly mounted to a PCB. The present underfill structures may be used on a wide variety of interconnect structures, such as solder bumps, metal pillars, and the like. Interconnect structures may be composed of solder, as in the case of solder bumps, or of a non-solder material with a solderable cap. Exemplary solders used to form solder bumps include, but are not limited to, tin, tin-lead, tin-silver, tin-bismuth, tin-copper, tin-silver-copper, and the like. Exemplary metal pillars are copper pillars. Metal pillars have a solderable cap portion, where such solderable cap may be any suitable solder. Metal pillars may also include one or more metal layers, such as a nickel layer, disposed between the metal and the solderable cap layer. Such interconnect structures have a wide variety of sizes, depending upon the design of the component.

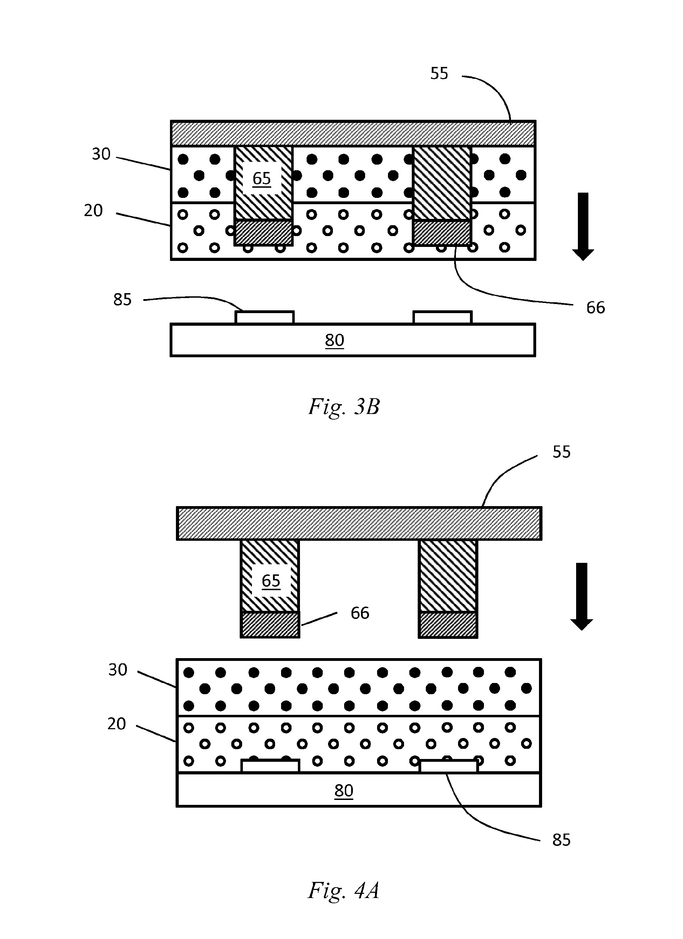

After the underfill structure is laminated to a substrate surface, the top film layer is removed, along with any optional buffer layer, to provide pre-applied underfill on the substrate surface. Figs. 3A and 3B illustrate one arrangement where the underfill structure of Figs. 1A and 1B, respectively, are laminated to a component having interconnect structures. Following removal of the top film layer, an upper portion of the interconnect structures (metal pillars) may be exposed above the surface of polymer layer or may be covered by either the first or second polymer region of the polymer layer, to provide a pre-applied underfill on the component. Whether the interconnect structures are covered by the polymer layer or not depends on the height of the polymer layer relative to the height of the interconnect structures. Fig. 3A shows a preferred arrangement where the underfill structure of Fig. 1A is laminated to a component (active device) **55** having interconnect structures **65** thereon, where the interconnect structures have a solderable cap layer **66,** such that the second filled polymer region **30** having the relatively higher viscosity is directly adjacent to the component surface. Fig. 3B shows an alternate arrangement where the underfill structure of Fig. 1B is laminated to a component (active device) **55** having interconnect structures **65** thereon, where the interconnect structures have a solderable cap layer **66,** such that the first filled polymer region **20** having the relatively lower viscosity is directly adjacent to the component surface. In both Figs. 3A and 3B, the polymer layer is shown to be higher than the total height of the interconnect structures **65** and solderable cap layer **66,** although the polymer layer may have the same height as, or a lower height than the he total height of the interconnect structures. Next, the component is mounted to a substrate. The top portion of interconnect structures **65,** that is the solderable cap layer **66,** is registered with conductive bond pads **85** on substrate (such as a PCB) **80,** and the solderable cap layers **66** are brought into contact with the conductive bond pads **85,** as indicated by the arrow in Figs. 3A and 3B, to form a unit.

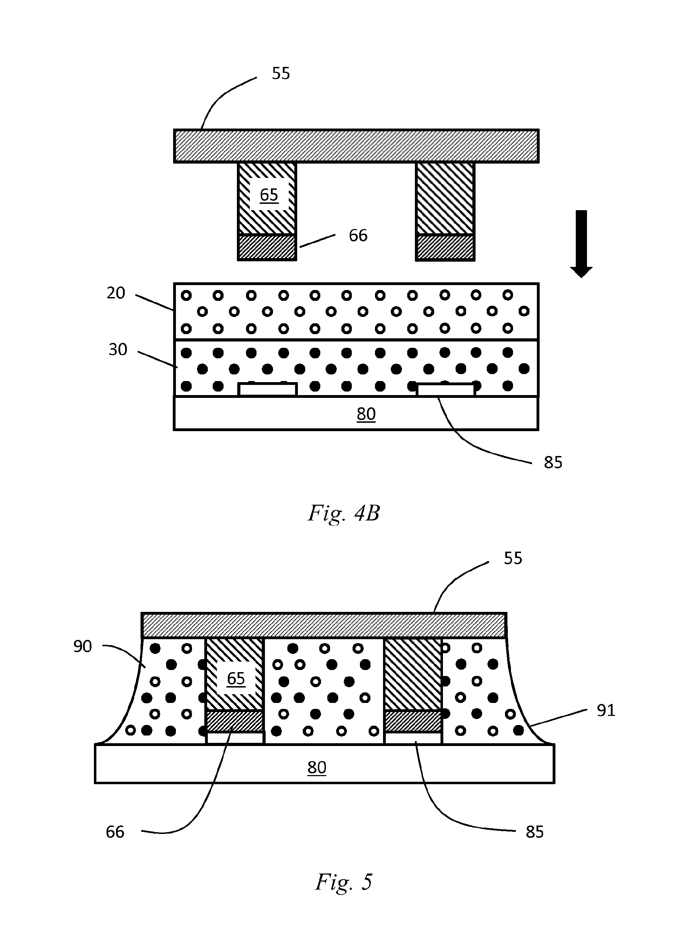

Figs. 4A and 4B illustrate an alternate arrangement where the underfill structure of Figs. 1B and 1A, respectively, are laminated to a substrate having conductive bond pads on the surface thereof. Following removal of the top film layer, a substrate having a pre-applied underfill structure over the conductive bond pads is obtained. The height of the polymer layer (combined height of the first polymer region **20** and second polymer region **30)** in Figs. 4A and 4B is driven by the total height of the interconnect structures used, and as a result is much greater than the height of the conductive bond pads **85.** Fig. 4A shows a preferred arrangement where the underfill structure of Fig. 1B is laminated to a substrate (such as a PCB) 80 having conductive bond pads **85** on the surface thereof, such that the first polymer region having the relatively lower viscosity is directly adjacent to the substrate surface. Fig. 4B shows an alternate arrangement where the underfill structure of Fig. 1A is laminated to a substrate (such as a PCB) **80** having conductive bond pads **85** on the surface thereof, such that the second polymer region having the relatively higher viscosity is directly adjacent to the substrate surface. Next, a component (active device) **55** having interconnect structures **65** thereon, where the interconnect structures have a solderable cap layer **66,** is mounted to the substrate having the pre-applied underfill thereon. The top portion of interconnect structures **65,** that is the solderable cap layer **66,** is registered with conductive bond pads **85** on substrate (such as a PCB) **80,** and the solderable cap layers **66** are brought into contact with the conductive bond pads **85,** as indicated by the arrow in Figs. 4A and 4B, to form a unit.

After the interconnect structures of the component are brought into contact with the conductive bond pads on the mounting substrate to form a unit, the unit is subjected to conditions to electrically connect the interconnect structures with the conductive bond pads. Such conditions include, but are not limited to, thermocompression bonding and heating the unit, typically with pressure being applied to either the component, the mounting substrate or both, to at least partially melt the interconnect structures and electrically connect (solder) the interconnect structures to the conductive bond pads. During this heating step, the pre-applied underfill (polymer layer) further cures (polymerizes). The polymer layer is typically cured by heating for a sufficient time period to cause the polymer layer to polymerize. Such time period will depend, in part, on the curable polymers used, crosslinkers used, whether any thermal curing agents are used, and on the thickness of the total polymer layer, but is typically from 5 minutes to 5 hours, and preferably from 10 minutes to 2 hours. When a thermal curing agent is used, the underfill should be heated to a temperature equal to or higher than that temperature required to activate the curing agent. Preferably, the underfill is cured by heating to a temperature in the range of 100 to 250 °C, more preferably from 100 to 200 °C, and yet more preferably from 125 to 200 °C. Particularly preferred curing conditions are heating the underfill at 150 to 175 °C for 30 minutes to 2 hours.

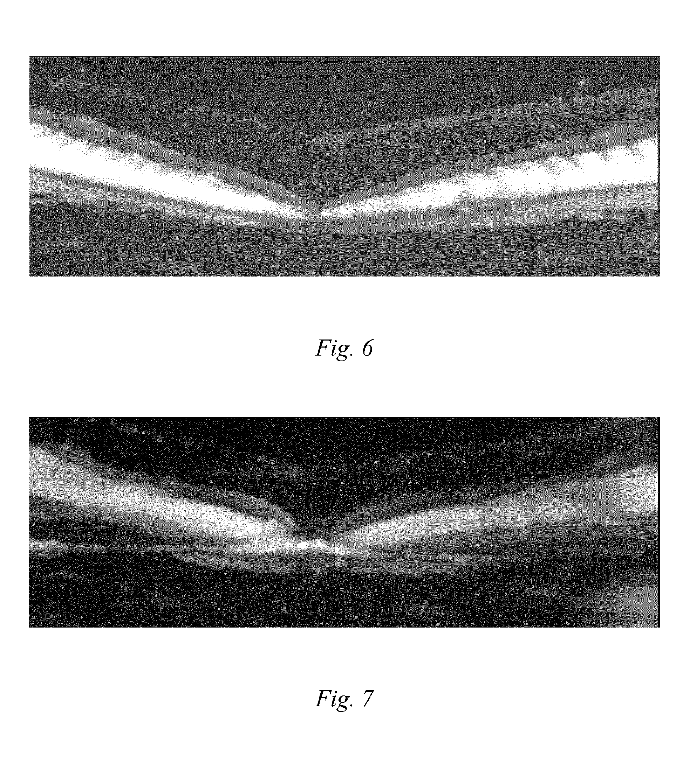

After the interconnect structures are electrically connected to the conductive bond pads and the underfill is cured, an electronic package is obtained. Fig. 5 illustrates an electronic package formed according to the present invention having component **55** mounted on substrate **80** with interconnect structures **65** electrically connected to bond pads **85.** The electronic package of Fig. 5 is obtainable from the unit formed as shown in any of Figs. 3A, 3B, 4A and 4B. During curing of the polymer layer, the first polymer region, being relative less viscous than the second polymer region, flows to a greater extent than the second polymer region. As the first polymer region flows, it moves away from the forming electrical connection between the interconnect structures and the conductive bond pads, and flows out from between the component and the substrate, forming a bead or fillet **91** surrounding component **55** in Fig. 5. After curing, the first and second polymer regions form a unitary bulk region **90** in Fig. 5. While not wishing to be bound by theory, it is believed that such a unitary bulk region has a substantially uniform concentration of inorganic filler throughout the bulk. That is, the unitary bulk region is substantially free of an inorganic filler concentration gradient, and is preferably free of such a concentration gradient. The cured underfill of the present invention has a substantially uniform filler concentration throughout the underfill, and a substantially uniform CTE. The formation of a unitary bulk structure is aided, at least in part, by selecting polymers for the first and second polymer regions that are compatible with each other. Two or more polymers in a mixture are considered compatible when they do not form discrete domains upon curing, but instead form a single cured domain. Fig. 6 is a corner-on optical image of a component mounted to a substrate using the underfill structure of the invention and having a relatively uniform fillet formed along the edge of the component. Fig. 7 is a corner-on optical image of a component mounted to a substrate using a comparative underfill structure having only one polymer region which had a relatively high viscosity, resulting in a fillet that is less uniform and having a more rounded, less desirable shape.

The present invention offers a number of advantages. The relatively higher viscosity filled polymer region of the present invention is particularly suitable for reducing voiding in the underfill. The relatively lower viscosity filled polymer region is particularly suitable for fillet formation and for reducing entrapment of filler in electrical connections between interconnect structures and conductive bond pads. The present underfill structure having a first filled polymer region having a first viscosity and a second filled polymer region having a second viscosity, where the second viscosity is ≥ 1.5 times the first viscosity provides a unitary bulk structure having reduced voiding, good fillet formation, reduced entrapment of filler in the electrically conductive joints that are formed during the bonding process, and a substantially uniform CTE. Electronic packages formed from the present underfill structures have a cured underfill that is substantially free of voids, and preferably are free of voids. Further, such electronic packages preferably have good fillet formation. The amount of filler in the relatively lower viscosity polymer region provides fillets having the same CTE as the bulk underfill.

Example 1 - Preparation of Polymer 1. To a jacketed 3 L reactor fitted with an overhead stirrer, thermometer and condenser was added 2000 g (11.3 mol) of diglycidyl ether of bisphenol A (DER 332 from The Dow Chemical Company, EEW: 177) and 545.7 g propylene glycol monomethyl ether (PGME). The solution was heated to 50 °C and allowed to stir for 10 min. to ensure thorough mixing. After adequate agitation, a 182.8 g (4.3 mol) portion of 1,8-menthane diamine (Primine MD from The Dow Chemical Company) was added with stirring and the resulting mixture was heated to 100 °C. Once stabilized at 100 °C, the mixture was stirred for 1 hour, after which the heat was further increased to 130 °C and the material allowed to stir for an additional 4 hours. After the reaction was completed, the temperature was lowered and the b-staged polymer was dropped into a 4 L glass bottle for storage.

Example 2 - Preparation of Polymer 2. To a jacketed 3 L reactor fitted with an overhead stirrer, thermometer and condenser was added 1100.8 g (6.2 mol) of diglycidyl ether of bisphenol A (DER 332, EEW: 177), 820.9 g (1.9 mol) of a flexibilizer having epoxy functionalities (EPICLON™ EXA-4850-150, DIC Corporation, EEW 450) and 675.0 g PGME. The solution was heated to 50 °C and allowed to stir for 10 min. to ensure thorough mixing. After adequate agitation, a 103.3 g (2.4 mol) portion of 1,8-menthane diamine was added with stirring and the resulting mixture was heated to 100 °C. Once stabilized at 100 °C, the mixture was stirred for 1 hour, after which the heat was further increased to 130 °C and the material allowed to stir for an additional 4 hours. After the reaction was completed, the temperature was lowered and the b-staged polymer was dropped into a 4 L glass bottle for storage.

Example 3 - Preparation of Polymers. Various polymer materials are prepared by repeating the procedure of Example 1 or Example 2 except that the bisphenol A epoxy is replaced with a molar equivalent of a difunctional epoxy monomer listed in Table 1.

**Table 1**

| **Polymer Sample** | **Epoxy** | **Procedure** |
|---|---|---|
| 3 | Diglycidyl ether of bisphenol S | Example 1 |
| 4 | Diglycidyl ether of anthracene | Example 1 |
| 5 | Diglycidyl ether of naphthalene | Example 2 |
| 6 | Diglycidyl ether of bisphenol F | Example 1 |
| 7 | Diglycidyl ether of dicyclopentadiene | Example 2 |

Example 4 - Preparation of Polymers. Various polymer materials are prepared by repeating the procedure of Example 1 or Example 2 except that the epoxy monomers and amine crosslinkers reported in Table 2 are used.

**Table 2**

| **Polymer Sample** | **Epoxy** | **Amine Crosslinker** | **Procedure** |
|---|---|---|---|
| 8 | Diglycidyl ether of bisphenol S | EHGE-Primene MD adduct | Example 2 |
| 9 | Diglycidyl ether of bisphenol A | 2,6-Diamino-2,5,6-trimethylheptan-3-ol | Example 2 |
| 10 | Diglycidyl ether of bisphenol F | 2,6-Diamino-2,6-dimethyl-5-phenylheptan-3-ol | Example 1 |
| 11 | Diglycidyl ether of naphthalene | 2,6-Diamino-2,6-dimethyl-5-phenylheptan-3-ol | Example 2 |
| 12 | Diglycidyl ether of dicyclopentadiene | Polytetramethyleneoxide-di-p-aminobenzoate | Example 1 |
| 13 | Diglycidyl ether of dicyclopentadiene | Trimethyleneglycol di-p-aminobenzoate | Example 1 |
| 14 | Diglycidyl ether of bisphenol S | 2,6-Diamino-2,5,6-trimethylheptan-3-ol | Example 2 |

Examples 5 - General Preparation Method for Polymer Formulations. The following general procedure is used for preparing the compositions of Examples 6-8, using the polymer samples of Examples 1-4, the inorganic filler from Table 3, and the other components from Table 4. Inorganic filler is first combined with the wetting agent (HYPERMER™ KDI, from Croda, Inc.) and dispersed in a solvent mixture composed of a 50:50 blend of n-butyl acetate/PGME using a double planetary mixer set for 5 min and 2000 rpm. To this filler slurry is added the Polymer Sample and any monomer and the resulting mixture is again spun in the double planetary mixer for 5 min. at a speed of 2000 rpm. The flow additive (TEGOFLOW™ 370, from Evonik Industries AG), hardener, and toughening agent (BTA 753ER, from The Dow Chemical Company) are all then added and the resulting mixture is spun in the double planetary mixer for 5 min. at a speed of 2000 rpm. Lastly, the catalyst is added and the resulting formulation is once more spun in the double planetary mixer for 5 min. at a speed of 2000 rpm. Once all the materials are compounded together, the resulting formulation is passed through a Netzsch media mill containing 0.8 mm zirconium oxide grinding media to ensure any filler agglomerates are broken up, thereby producing a viscous, free-flowing liquid.

**Table 3**

| **Inorganic Filler Sample** | **Filler (average particle size)** |
|---|---|
| 1 | Fused Silica (80 µm) |
| 2 | Silica (10 µm) |
| 3 | Aluminum nitride (50 µm) |
| 4 | Aluminum nitride (10 µm) |
| 5 | Zirconia (< 100 µm) |
| 6 | Boron Nitride (11 µm) |
| 7 | Alumina (85 µm) |
| 8 | Alumina (8 µm) |

**Table 4**

| **Component** | **Material** | **Trade Name** | **Supplier** |
|---|---|---|---|
| Monomer 1 | Epoxy monomer | EPICLON HP4700 | DIC Corporation |
| Monomer 2 | Epoxy monomer | EPICLON EXA-4850-150 | DIC Corporation |
| Hardener 1 | Dicyandiamide | OMICURE DDA5 | CVC Thermoset |
| Hardener 2 | Phenolic Hardener | MEH-7851SS | Meiwa Kasei |
| Hardener 3 | Phenolic Hardener | MEH-7500 | Meiwa Kasei |
| Catalyst 1 | Cycloaliphatic bisurea | OMICURE U35M | CVC Thermoset |
| Catalyst 2 | tetraphenylphosphonium tetraphenylborate | | Hokko Chemical Industry Co |
| Catalyst 3 | tetrabutylphosphonium hexafluorophosphate | | TCI America |
| Catalyst 4 | Phenyl dimethyl urea | OMICURE U-405 | CVC Thermoset |

Example 6 - High Viscosity Polymer Formulations. High viscosity polymer formulations (HVF) are prepared by combining the components in the amounts (in grams) shown in Table 5 according to the general procedure of Example 5.

**Table 5**

| **HVF:** | **1** | **2** | **3** | **4** | **5** | **6** | **7** |
|---|---|---|---|---|---|---|---|
| Polymer 1 | 20 | 20 | 20 | 20 | 20 | 20 | 20 |
| Monomer 1 | 9 | 9 | 9 | 9 | - | - | 9 |
| Inorganic Filler 1 | 15.4 | 11.6 | 40 | 35.6 | 22.8 | 23.4 | 74.1 |
| Inorganic Filler 2 | 3.9 | 7.7 | 20 | 9.3 | 5.7 | 5.8 | 18.5 |
| Hardener 1 | 2.5 | 2.5 | 2.5 | 2.5 | 1.6 | 1.6 | 2.5 |
| Catalyst 1 | 0.7 | 0.7 | - | 0.7 | - | 0.5 | 0.7 |
| Flow Additive | 0.2 | 0.2 | 0.4 | 0.4 | 0.4 | 0.4 | 0.6 |
| Toughening agent | 1 | 1 | 1.5 | 1.5 | 1.5 | 1.5 | 2.5 |
| Wetting agent | 0.1 | 0.1 | 0.2 | 0.2 | 0.1 | 0.1 | 0.4 |
| Solvent | 20.7 | 20.7 | 31.1 | 31.9 | 20.4 | 20.9 | 53.1 |

Example 7 - High Viscosity Polymer Formulations. High viscosity polymer formulations (HVF) are prepared by combining the components in the amounts (in grams) shown in Tables 6 and 7 according to the general procedure of Example 5.

**Table 6**

| **HVF:** | **8** | **9** | **10** | **11** | **12** | **13** | **14** | **15** |
|---|---|---|---|---|---|---|---|---|
| Polymer 1 | - | 15 | 20 | - | 20 | - | - | - |
| Polymer 2 | 20 | 5 | - | 20 | - | 15 | - | - |
| Polymer 4 | - | - | - | - | - | - | 20 | - |
| Polymer 6 | - | - | - | - | - | 5 | - | 20 |
| Monomer 1 | 6.8 | - | - | - | - | - | 6.8 | 6.8 |
| Inorganic Filler 1 | 13.7 | - | - | 23.2 | 48.5 | - | - | - |
| Inorganic Filler 2 | 3.4 | - | - | 6.3 | 15 | - | - | - |
| Inorganic Filler 3 | - | 9.7 | 7.3 | - | - | - | - | 67.5 |
| Inorganic Filler 4 | - | 2.4 | 4.9 | - | - | - | - | 16.9 |
| Inorganic Filler 7 | - | - | - | - | - | 49.1 | 14.1 | - |
| Inorganic Filler 8 | - | - | - | - | - | 12.3 | 3.5 | - |
| Hardener 1 | 2.2 | 1.6 | 1.6 | 1.6 | 1.6 | 1.6 | 2.2 | 2.2 |
| Catalyst 1 | - | - | - | 0.5 | - | 0.5 | 0.7 | 0.7 |
| Flow Additive | 0.2 | 0.2 | 0.2 | 0.4 | 0.6 | 0.6 | 0.2 | 0.6 |
| Toughening agent | 0.9 | 0.9 | 0.9 | 1.4 | 2.5 | 2.3 | 0.9 | 2.3 |
| Wetting agent | 0.1 | 0.1 | 0.1 | 0.1 | 0.2 | 0.2 | 0.1 | 0.3 |
| Solvent | 18.4 | 13 | 13.1 | 20.8 | 34.7 | 35.2 | 18.8 | 48.4 |

**Table 7**

| **HVF:** | **16** | **17** | **18** | **19** | **20** | **21** | **22** | **23** |
|---|---|---|---|---|---|---|---|---|
| Polymer 1 | 20 | 20 | 15 | - | - | - | - | 5 |
| Polymer 2 | - | - | 5 | - | - | 10 | 15 | - |
| Polymer 4 | - | - | - | 20 | - | - | 5 | 15 |
| Polymer 6 | - | - | - | - | 20 | 10 | - | - |
| Monomer 2 | - | 10.8 | - | 10.8 | - | - | 10.8 | 10.8 |
| Inorganic Filler 1 | 15 | 23.7 | 11.3 | - | - | - | - | - |
| Inorganic Filler 2 | 3.8 | 5.9 | 7.5 | - | - | - | 29.3 | - |
| Inorganic Filler 3 | - | - | - | - | 34.8 | 73.7 | 111 | - |
| Inorganic Filler 4 | - | - | - | - | 8.7 | 18.4 | - | - |
| Inorganic Filler 7 | - | - | - | 55.2 | - | - | - | 17.8 |
| Inorganic Filler 8 | - | - | - | 13.8 | - | - | - | 11.9 |
| Hardener 2 | 10.8 | 15.5 | 10.8 | 15.5 | 10.8 | 10.8 | 15.5 | 15.5 |
| Catalyst 2 | 0.5 | - | - | 1.1 | - | - | - | - |
| Catalyst 3 | - | 0.7 | 0.5 | - | 0.7 | 1.2 | 1.9 | 0.7 |
| Flow Additive | 0.3 | 0.4 | 0.3 | 0.6 | 0.4 | 0.6 | 1 | 0.4 |
| Toughening agent | 1 | 1.5 | 1 | 2.4 | 1.5 | 2.5 | 4 | 1.5 |
| Wetting agent | 0.1 | 0.1 | 0.1 | 0.3 | 0.2 | 0.4 | 0.6 | 0.1 |
| Solvent | 20.2 | 31.8 | 20.2 | 49.4 | 31.1 | 52.8 | 52.8 | 31.8 |

Example 8 - Low Viscosity Polymer Formulations. Low viscosity polymer formulations (LVF) are prepared by combining the components in the amounts (in grams) shown in Tables 8 and 9 according to the general procedure of Example 5.

**Table 8**

| **LVF:** | **1** | **2** | **3** | **4** | **5** | **6** | **7** | **8** |
|---|---|---|---|---|---|---|---|---|
| Polymer 1 | - | 20 | 10 | - | - | - | - | - |
| Polymer 2 | 20 | - | 10 | - | - | 15 | 10 | 20 |
| Polymer 4 | - | - | - | 20 | - | - | 10 | - |
| Polymer 6 | - | - | - | - | 20 | 5 | - | - |
| Monomer 1 | 6.8 | 9 | - | 9 | 6.8 | 9 | - | - |
| Inorganic Filler 1 | 17.1 | 19.3 | - | - | - | - | - | 61.4 |
| Inorganic Filler 3 | - | - | 12.5 | - | 40.5 | - | - | - |
| Inorganic Filler 5 | - | - | - | 44.9 | - | - | 59.9 | - |
| Inorganic Filler 7 | - | - | - | - | - | 90.4 | - | - |
| Hardener 1 | 2.2 | 2.5 | 1.6 | 2.5 | 2.2 | 2.5 | 1.6 | 1.6 |
| Catalyst 1 | - | 0.7 | 0.5 | 0.7 | 0.7 | - | - | 0.5 |
| Flow Additive | 0.2 | 0.2 | 0.2 | 0.4 | 0.4 | 0.6 | 0.6 | 0.6 |
| Toughening agent | 0.9 | 1 | 0.9 | 1.5 | 1.4 | 2.5 | 2.3 | 2.3 |
| Wetting agent | 0.1 | 0.1 | 0.1 | 0.2 | 0.2 | 0.4 | 0.2 | 0.2 |
| Solvent | 18.4 | 20.7 | 13.4 | 31.9 | 29 | 51.8 | 34.4 | 35.2 |

**Table 9**

| **LVF:** | **9** | **10** | **11** | **12** | **13** | **14** | **15** |
|---|---|---|---|---|---|---|---|
| Polymer 1 | 20 | - | - | - | - | - | 20 |
| Polymer 2 | - | 20 | - | 10 | - | 5 | - |
| Polymer 9 | - | - | - | | 20 | 15 | - |
| Polymer 14 | - | - | 20 | 10 | - | - | - |
| Monomer 2 | - | 10.8 | 10.8 | - | - | 10.8 | 10.8 |
| Inorganic Filler 1 | 18.8 | - | - | - | 92.1 | - | 69 |
| Inorganic Filler 3 | - | 29.6 | - | - | - | - | - |
| Inorganic Filler 5 | - | - | - | 43.5 | - | 140.3 | - |
| Inorganic Filler 7 | - | - | 69 | - | - | - | - |
| Hardener 2 | 10.8 | 15.5 | 15.5 | 10.8 | 10.8 | 15.5 | 15.5 |
| Catalyst 2 | 0.5 | - | 1.1 | - | 1.2 | - | - |
| Catalyst 3 | - | 0.7 | - | 0.7 | - | 1.9 | 1.1 |
| Flow Additive | 0.3 | 0.4 | 0.6 | 0.4 | 0.6 | 1 | 0.6 |
| Toughening agent | 1 | 1.5 | 2.4 | 1.5 | 2.5 | 4 | 2.4 |
| Wetting agent | 0.1 | 0.1 | 0.3 | 0.2 | 0.4 | 0.6 | 0.3 |
| Solvent | 20.2 | 31.8 | 49.4 | 31.1 | 52.8 | 52.8 | 49.4 |

Example 9 - Preparation of Underfill Structures. A high viscosity formulation from Tables 5 to 7 is coated using a slot die on a PET carrier film (bottom film). This coating is passed through a multi-stage oven with peak temperature of 110 °C to drive off the solvent resulting in a dry film. A low viscosity formulation from Tables 8 or 9 is coated onto a PET carrier and treated similarly to the high viscosity formulation. The two dry film materials are subsequently laminated together using a hot roll laminator and the PET cover sheet adjacent to the low viscosity material is removed. This assembly is next laminated to a backgrinding tape (top film layer) having a PSA layer using a hot roll laminator with the low viscosity material layer adhering to the adhesive layer on the backgrinding tape. The PET carrier film (bottom film) adjacent to the high viscosity material is peeled off and the exposed surface of the high viscosity material is then laminated onto a wafer using a vacuum laminator.

Example 10. High Viscosity Formulation 3 from Table 5 was coated on a PET carrier film (bottom film) using a slot die coater and dried according to the procedure of Example 9. Low Viscosity Formulation 15 from Table 9 was coated onto a PET carrier and treated similarly. The two dry film materials were subsequently laminated together using a hot roll laminator and the PET cover sheet adjacent to the low viscosity material was removed. This assembly was then laminated to a backgrinding tape (top film layer) having a PSA layer using a hot roll laminator with the low viscosity material layer adhering to the adhesive layer on the backgrinding tape. The PET carrier film (bottom film) adjacent to the high viscosity material was peeled off and the exposed surface of the high viscosity material is then laminated onto a PCB substrate to provide a PCB substrate having a pre-applied underfill material disposed thereon. The top film layer was then removed from the pre-applied underfill to expose the surface of the low viscosity region. A semiconductor die was then registered over the pre-applied underfill, mounted to the PCB substrate, and the pre-applied underfill material was then cured at 175°C for 90 minutes. During mounting of the die, the underfill material flowed out from between the die and the substrate to form a bead of cured underfill surrounding the die. Fig. 6 shows the edge-on optical image of this electronic package.

Example 11 - Comparative. The procedure of Example 10 was repeated except that High Viscosity Formulation 4 was used with no low viscosity formulation. That is, the underfill structure contained a polymer layer having a single high viscosity polymer region and no low viscosity polymer region. Fig. 7 shows the edge-on an optical image of this electronic package. It can be seen from Fig. 7 (comparative) that the underfill bead surrounding the die is less uniform than the underfill bead shown in Fig. 6 (invention).

## Claims

1. An underfill structure comprising in order: a top film layer; a polymer layer, and a bottom film layer, wherein the polymer layer comprises a first filled polymer region having a first viscosity and a second filled polymer region having a second viscosity, wherein the second viscosity is ≥ 1.5 times the first viscosity.

2. The underfill structure of claim 1 wherein the first viscosity is in the range of 0.1 to 1000 Pa-S at 120 °C.

3. The underfill structure of claim 1 wherein the second viscosity is in the range of 1000 to 100,000 Pa-S at 120 °C.

4. The underfill structure of claim 1 wherein the second viscosity is ≥ 2 times the first viscosity.

5. The underfill structure of claim 1 wherein the first filled polymer region comprises a first amount of inorganic filler and the second filled polymer region comprises a second amount of inorganic filler, wherein the first amount of inorganic filler is substantially the same as the second amount of inorganic filler.

6. The underfill structure of claim 1 wherein an adhesive layer is disposed between the top film layer and the polymer layer.

7. The underfill structure of claim 1 wherein the top film layer is composed of an elastomer.

8. The underfill structure of claim 1 wherein the top film layer is a polymer chosen from polyolefins, polyesters, polyurethanes, poly(vinyl chloride), poly(vinylidene chloride), ethylene vinyl acetate, and poly(meth)acrylates.

9. The underfill structure of claim 1 wherein the bottom film layer is chosen from polyester, polyamide, polyimide, polyolefin, polyacrylate, polyurethane, and metal.

10. The underfill structure of claim 1 wherein each of the first filled polymer region and second filled polymer region comprises a curable polymer, crosslinking agent, thermal curing agent and inorganic filler.

11. The underfill structure of claim 1 wherein the first filled polymer region has from 30 to 80 wt% of inorganic filler.

12. The underfill structure of claim 1 wherein the second filled polymer region has from 30 to 80 wt% of inorganic filler.

13. A method of forming an electronic package comprising: providing a component having interconnect structures on a surface thereof; providing a substrate having conductive bond pads on a surface thereof; providing the underfill structure of claim 1; removing the bottom film from the underfill structure; laminating the underfill structure to the component surface having interconnect structures thereon or the substrate surface having conductive bond pads thereon; removing the top film layer; registering a top portion of the interconnect structures with the conductive bond pads to form a unit; and causing the interconnect structures to electrically connect to the conductive bond pads.

14. The method of claim 13 wherein the underfill structure is arranged such that the first filled polymer region is directly adjacent to the substrate surface.
